(19) Europäisches Patentamt
European Patent Office
Office européen des brevets

(11) **EP 4 409 308 B1**

(12) **EUROPEAN PATENT SPECIFICATION**

(45) Date of publication and mention
of the grant of the patent:
**08.04.2026   Bulletin 2026/15**

(21) Application number: **21789860.0**

(22) Date of filing: **30.09.2021**

(51) International Patent Classification (IPC):
***G01R 31/367*** (2019.01)     ***G01R 31/392*** (2019.01)

(52) Cooperative Patent Classification (CPC):
**G01R 31/392; G01R 31/367**

(86) International application number:
**PCT/IB2021/059003**

(87) International publication number:
**WO 2023/052822 (06.04.2023 Gazette 2023/14)**

(54) **ESTIMATING BATTERY STATE OF HEALTH**

SCHÄTZUNG DES BATTERIEGESUNDHEITSZUSTANDS

ESTIMATION DE L'ÉTAT DE SANTÉ D'UNE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.08.2024   Bulletin 2024/32**

(73) Proprietor: **Cummins Inc.
Columbus, IN 47201 (US)**

(72) Inventors:
• **WANG, Yujun
  Columbus, Indiana 47201 (US)**
• **ZHANG, Ruigang
  Columbus, Indiana 47201 (US)**
• **HILLIGOSS, Lawrence
  Columbus, Indiana 47201 (US)**

(74) Representative: **Cleveland Scott York
5 Norwich Street
London EC4A 1DR (GB)**

(56) References cited:
**WO-A1-2020/246558     DE-A1- 102019 127 828
US-A1- 2018 246 173**

**Description**

The present invention relates to techniques for estimating the state of health of a battery. The present invention has particular, but not exclusive, application in estimating the state of health of a battery for traction applications, for example, a battery pack for an electric or hybrid electric vehicle.

Electric vehicles and hybrid electric vehicles, such as cars, buses, vans and trucks, use battery packs that are designed with a high ampere-hour capacity in order to give power over sustained periods of time. A battery pack comprises a large number of individual electrochemical cells connected in series and parallel to achieve the total voltage and current requirements. Typically, Lithium ion (Li-ion) battery cells are used as they provide a relatively good cycle life and energy density.

Battery packs typically contain a battery management system (BMS) which is responsible for monitoring and management of the cells in the battery pack. During operation, the battery management system may estimate an inner state of the battery, such a state of charge (SOC) and/or a state of health (SOH). The SOC provides information about the current amount of energy stored in the battery, and thus may be used an indicator of available range. The SOH is a figure of merit that indicates the level of battery degradation.

Knowledge of the battery's SOH is useful for an operator when organising maintenance and replacement schedules. Furthermore, if the SOH is monitored in real time, it can allow battery fault diagnosis which may help to prevent hazardous situations from arising. Real time SOH estimation can also provide knowledge about the battery performance that can help to manage the energy distribution. In addition, real time SOH estimation can help with accurate estimation of the battery state of charge (SOC). This may help to provide a reliable estimate of available range for the vehicle.

Known techniques for estimating the battery SOH involve the use of algorithms such as a Kalman filter. Exemplary Kalman filters include a dual nonlinear Kalman filter, an extended Kalman filter, an unscented Kalman filter, a cubature Kalman filter, and the like. The Kalman filter estimates the SOH of the battery by calculating estimated SOH values and corresponding error bounds.

It has been found that, while a Kalman filter can provide a reasonable estimate of SOH, it may have a high noise level, which may fluctuate over time, and may not always provide the required accuracy.

It would therefore be desirable to provide techniques for estimating the SOH of a battery which can improve the estimation accuracy and/or reduce noise levels.

WO 2020/246558 discloses a battery control apparatus which can determine the state of charge (SOC), state of health (SOH) and a maximum charge-discharge current of a battery. A battery controller stores relationships between the SOC and values of parameters such as the DC resistance and the polarization resistance at various temperatures, as a data table. The battery controller can then estimate the SOC on the basis of information sent from a cell controller using the stored relationships. The SOH is calculated based on the ratio between an actual charge-discharge amount over a certain time period, and an expected charge-discharge amount for the battery in its initial (non-degraded) state.

According to one aspect of the invention there is provided apparatus for determining a state of health of a battery as defined in claim 1.

The present invention may provide the advantage that, by estimating values of a plurality of equivalent circuit model parameters of the battery and calculating a state of health of the battery using predetermined relationships between the equivalent circuit model parameters and the battery state of health, it may be possible to provide a state of health estimation which is more robust and stable than previous approaches.

It has been found experimentally that there may be a correlation between battery capacity and the value of battery characterization time (R1C1) or diffusion capacitance (C1). Thus, in one embodiment, an equivalent circuit model parameter is one of characterization time (R1C1) and diffusion capacitance (C1).

The value of the equivalent circuit model parameter may be estimated from a response to a step change in current through the battery. For example, the step change in current may be a drop in charging current during charging of the battery. The drop in current may be to zero, or some other value. This may provide a convenient way of allowing the current value of the equivalent circuit model parameter to be estimated.

The apparatus may further comprise means for initiating the drop in charging current. For example, when a new state of health estimate is required, a special charging protocol may be initiated. The special charging protocol may comprise reducing the charging current to zero (or some other value) when the battery voltage exceeds a predetermined value (indicating that the battery has been charged to a predetermined level).

Alternatively, or in addition, the step change in current could be caused by vehicle shut off, or some other event such as removal of an electrical load. The step change in current may be a drop in current or an increase in current. A combination of different events could be used to estimate the value of the equivalent circuit model parameter.

In one embodiment, the equivalent circuit model parameters comprise characterization time (R1C1) and the value of the characterization time is estimated from the time taken for the voltage to decay to a predetermined value following the step change in current. The predetermined value may be a predetermined portion of a total change in voltage according to a relaxation curve following the step change in current. This may provide a convenient way of estimating the characterization time, and thus providing an estimate of battery state of health.

Preferably the predetermined relationships between the equivalent circuit model parameters and the battery state of health are obtained from battery aging data. For example, the relationships may be determined in advance from battery aging data and then stored in the storage unit for use in estimating battery state of health.

It has been found experimentally that the relationship between an equivalent circuit model parameter and the battery state of health can be modelled as a function. The function may be, for example, a polynomial function, or any other type of function such as a spline, a Padé approximant, or a trigonometric polynomial using a Fourier series. Thus, a predetermined relationship between the equivalent circuit model parameter and the battery state of health may be a function. In this case, the function may have been fitted in advance to data points in the battery aging data. This may be done, for example, using polynomial regression techniques, or in any other way. The function may be for example an nth degree polynomial function, where n is a natural number such as 2, 3, 4, 5, 6, 7, 8, 9 or any other number. Alternatively, a look up table or other types of function could be used instead.

The predetermined relationships between the equivalent circuit model parameters and the battery state of health are stored in the storage unit. This can allow the relationships to be stored locally and retrieved when it is required to estimate the state of health. Thus, the apparatus may comprise a memory in which the predetermined relationships are stored. In this case, the apparatus may further comprise means for updating the relationships between the equivalent circuit model parameters and the battery state of health stored in memory. For example, the apparatus may comprise communications means (such as a communications unit) which may allow the relationships to be updated using a wired or wireless connection. For example, in one embodiment, the apparatus may further comprise wireless communication means arranged to receive an updated relationship between an equivalent circuit model parameter and the battery state of health, and the updating means may be arranged to store the updated relationship in the memory.

It has been found experimentally that there may be a correlation between battery capacity and each of characterization time (R1C1), diffusion capacitance (C1), ohmic resistance (R0) and diffusion resistance (R1). Thus, the equivalent circuit model parameters are selected from: characterization time (R1C1); diffusion capacitance (C1); ohmic resistance (R0); and diffusion resistance (R1). This may help to provide a robust and accurate estimate of state of health.

Where the equivalent circuit model parameters comprise ohmic resistance (R0), the value of the ohmic resistance may be estimated from an initial change in voltage following a step change in current. Where the equivalent circuit model parameters comprise diffusion resistance (R1), the value of the diffusion resistance may be estimated from a change in voltage over time according to a relaxation curve following a step change in current. Where the equivalent circuit model parameters comprise diffusion capacitance (C1), the value of diffusion capacitance may be estimated from values of diffusion resistance (R1) and characterization time (R1C1). However, any other appropriate technique may be used as well or instead to estimate the values of the equivalent circuit model parameters. For example, the values of one or more of R0, R1 and C1 could be estimated using Kalman filter estimation as well or instead.

The state of health is calculated using the predetermined relationships between the equivalent circuit model parameters and the battery state of health. The predetermined relationships may be obtained from battery aging data. The predetermined relationships may be, for example, polynomial functions. Preferably the predetermined relationships are stored in memory. Means may be provided for updating the predetermined relationships.

If desired, it would be possible to monitor each state of health value individually. However, in a preferred embodiment, the state of health values are combined. Thus, the apparatus may further comprise means for combining the plurality of calculated state of health values to produce a combined state of health value. This may allow a single value indicating overall state of health to be produced using a plurality of equivalent circuit model parameters.

The combining means may be arranged to combine the plurality of calculated state of health values based on confidence levels of the respective values. For example, where polynomial functions are used to model the relationships between the equivalent circuit model parameters and the battery state of health, those functions may have different variances (deviations from the mean). Thus, the combining means may be arranged to combine the state of health values based on variances of the relationships between the equivalent circuit model parameters and the battery state of health. This may be done, for example, using a weighted average, where the weights are based on the variances. The variances may be obtained from battery aging data and may be stored in memory. If desired, confidence levels in the estimated values of the equivalent circuit model parameters could be used as well or instead. By combining the state of health values based on confidence levels, a more reliable estimate of the state of health may be achieved.

If desired, a temperature measurement may also be used when estimating a value of an equivalent circuit model parameter, such as a resistance. Thus, the apparatus may further comprise means for sensing a temperature of the battery. In this case, the value of an equivalent circuit model parameter may be estimated based further on a sensed temperature. This may allow the accuracy of the estimation to be improved. For example, the estimated value of the equivalent circuit model parameter could be corrected based on the sensed temperature, or the estimated value could be used only when the sensed temperature is within a predetermined temperature range. A temperature sensor may already be provided, for example, as part of a battery management system, and therefore this may be achieved at little or no additional cost.

If desired, the voltage and current of the whole battery may be monitored and used to estimate the battery state of health. However, in practice, it may be desirable to monitor the state of health of individual cells or groups of cells within a battery as well or instead. This may help with managing cell charge and discharge, and may provide an early indication of a potential fault in a cell or group of cells. Thus, in a preferred embodiment:

the battery comprises a plurality of battery cells;
the means for sensing a voltage is arranged to sense a voltage of each of a plurality of cells or groups of cells;
the estimating means is arranged to estimate a value of an equivalent circuit model parameter of each of the plurality of cells or groups of cells from the sensed voltage of that cell or group of cells and the sensed current; and
the calculating means is arranged to calculate a state of health of each of the plurality of cells or groups of cells based on the estimated value of the equivalent circuit model parameter of that cell or group of cells.

In the case of a group of cells, the group may be a group of cells which are connected in parallel. For example, where the cells are connected in a series/parallel configuration, such as a 2p, 3p, 4p or 5p configuration, the group may be a group of parallel connected cells, with each group connected in series. However, other configurations and other cell groupings could be used as well or instead.

Preferably, a plurality of equivalent circuit model parameters of each cell or group of cells are used to estimate the state of health of the cell or group of cells. Thus, in a preferred embodiment, the estimating means is arranged to estimate values of a plurality of equivalent circuit model parameters of each of the plurality of cells or groups of cells from the sensed voltage of that cell or group of cells and the sensed current, and the calculating means is arranged to calculate a state of health of each of the plurality of cells or groups of cells based on the estimated values of the plurality of equivalent circuit model parameters of that cell or group of cells. The plurality of equivalent circuit model parameters may be selected from: characterization time (R1C1); diffusion capacitance (C1); ohmic resistance (R0); and diffusion resistance (R1).

If desired, the state of health of each cell or group of cells could be output individually. This may help to identify a cell or group of cells which is failing and may help to give an overall picture of the battery state of health. However, it may be desirable to have a value indicating overall state of health of the battery as well or instead. Thus, the apparatus may further comprise means for combining the state of health of each of the plurality of cells or groups of cells to produce a battery state of health.

In one embodiment, the apparatus is part of a battery management system, for example, for a battery pack. The system may be, for example, an onboard system for an electric or hybrid electric vehicle, although other applications are also possible.

The parameter estimating unit, SOH calculation unit and combining means may be implemented as software executing on a processor with associated memory.

According to another aspect of the invention there is provided a battery comprising apparatus for determining a state of health in any of the forms described above. The battery may be for example a battery pack for an electric or hybrid electric vehicle.

Corresponding methods may also be provided. Thus, according to another aspect of the present invention there is provided a method of determining a state of health of a battery as defined in claim 15.

Features of one aspect of the invention may be used with any other aspect. Any of the apparatus features may be provided as method features and vice versa.

Preferred features of the present invention will now be described, purely by way of example, with reference to the accompanying drawings, in which:

Figure 1 is a block diagram of an example drive system in a hybrid electric vehicle;
Figure 2 shows parts of a typical battery pack for use in an electric or hybrid electric vehicle;
Figure 3 shows parts of a battery module in one possible configuration;
Figures 4A and 4B illustrate two possible configurations of battery cells in a battery module;
Figure 5 shows a first order equivalent circuit model for a typical battery;
Figure 6 shows a plot of battery SOH against ohmic resistance; Figure 7 shows a plot of battery SOH against diffusion resistance;
Figure 8 shows a plot of battery SOH against characterization time;
Figure 9 shows a plot of battery SOH against diffusion capacitance;
Figure 10 shows parts of a system for determining a state of health of a battery in an embodiment of the invention;
Figure 11 shows parts of an SOH estimation module;
Figure 12 illustrates values of voltage and current during initial charging and following a step change in current;
Figure 13 shows parts of an SOH estimation module in another embodiment;
Figure 14 is a flowchart of steps taken to obtain models of relationships between SOH and equivalent circuit model parameters; and
Figure 15 is a flowchart showing steps taken to calculate the SOH of a battery in one embodiment.

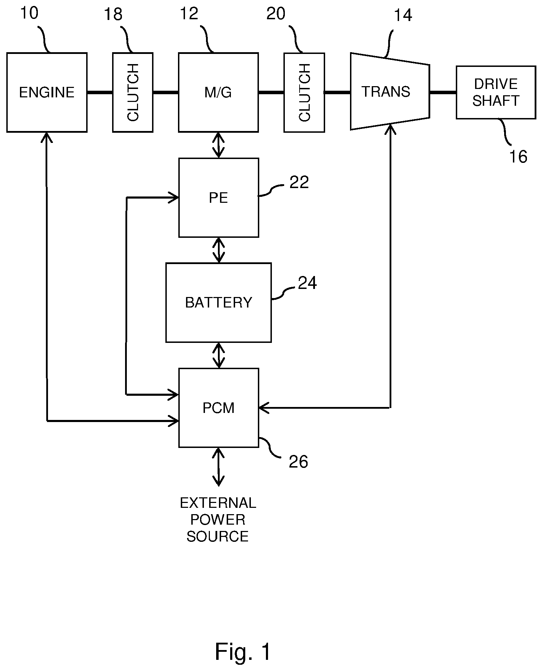

Figure 1 is a block diagram of an example drive system in a hybrid electric vehicle. Referring to Figure 1, the drive system comprises an internal combustion engine 10, an electric motor/generator 12, a transmission 14 and a drive shaft 16. A first clutch 18 is located between the engine 10 and the motor/generator 12. A second clutch 20 is located between the motor/generator 12 and the transmission 14. The motor/generator 12 is controlled by a power electronics module 22 and powered by a battery 24, which may be in the form of a battery pack. A powertrain control module 26 controls the operation of the engine 10, the PE module 22, the battery 24 and the transmission 14. In this embodiment the engine may be an auxiliary power unit such as a range extender which charges the battery when the battery is depleted. The battery 24 can also be charged from an external power source, such as an electric grid. In addition, the battery may be charged by regenerative braking. It will be appreciated that the arrangement of Figure 1 is given by way of example only, and other configurations of electric or hybrid electric vehicle, such as series hybrid, parallel hybrid or pure electric, are also possible.

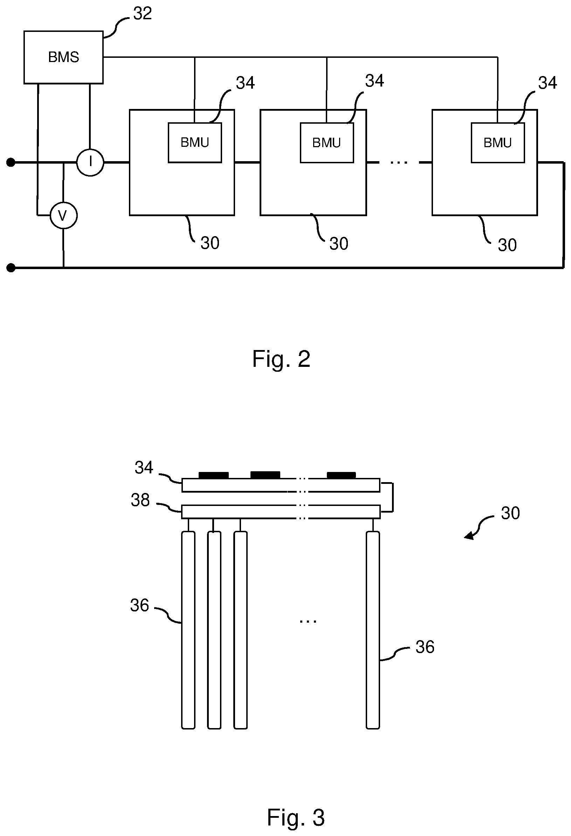

Figure 2 shows parts of a typical battery pack for use in an electric or hybrid electric vehicle. Referring to Figure 2, the battery pack comprises a plurality of battery modules 30 electrically connected in series and/or parallel to achieve the target pack voltage. A battery management system 32 monitors the voltage and current and manages overall operation of the battery pack. Each battery module 30 comprises a plurality of battery cells electrically connected in series and/or parallel. Each battery module 30 includes a battery management unit 34 which monitors and manages charge and discharge of the cells in that module. Although not shown in Figure 2, each battery management unit 34 includes voltage sensors which sense the voltages of individual cells or groups of cells. Each battery management units may also include one or more temperature sensors which sense the temperature of the module and/or individual cells or groups of cells. The battery management system 32 communicates with the battery management unit 34 in each of the modules 30 to monitor and manage overall operation of the battery pack. The battery management system and each of the battery management units include a processor with the appropriate software, along with memory and other components, which are used to monitor and manage charge and discharge. The battery pack may be, for example, as disclosed in GB 2593187 A, GB 2598534 A and GB 2594916 A.

Figure 3 shows parts of a battery module in one possible configuration. Referring to Figure 3, the battery module comprises a plurality of battery cells 36, a busbar 38 and a battery management unit 34. In this embodiment, the battery cells 36 are pouch cells or prismatic cells stacked together side-by-side. However, other types of cell, such as cylindrical cells, could be used instead. The busbar 38 is used to connect the battery cells 36 in the required series/parallel configuration. The busbar 38 includes voltage sensors which monitor the voltages of individual battery cells, or groups of battery cells connected in parallel. A current sensor senses total current through the module. In addition, one or more temperature sensors are used to sense the temperature of the module. The busbar 38 is connected to the battery management unit 34. The battery management unit receives the sensed voltages, current and temperature. The sensed voltages, current and temperature are used to monitor and manage cell charge and discharge.

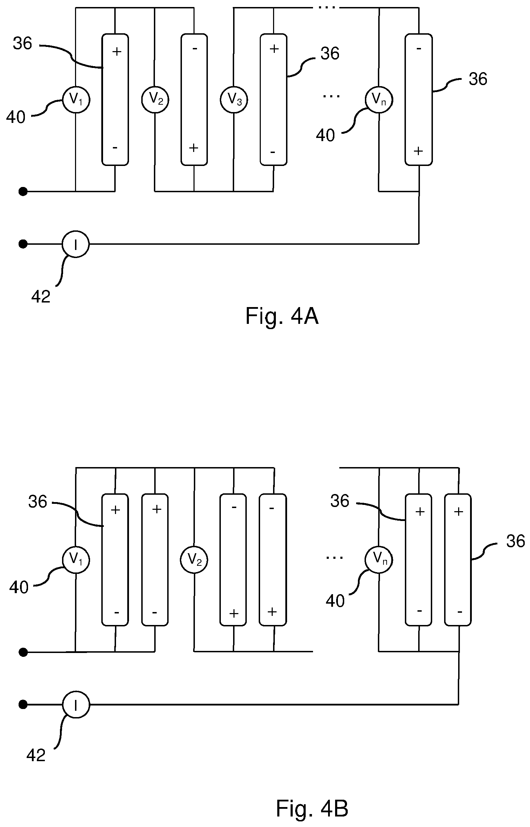

Figure 4A illustrates one possible configuration of battery cells in a battery module. In the arrangement of Figure 4A, a plurality of battery cells 36 are connected in series. The voltage of each of the battery cells is monitored with a voltage sensor 40. The sensed voltage from each of the voltage sensors is provided to a battery management unit (not shown). The current into or out of the battery module is monitored by a current sensor 42 and provided to the battery management unit.

Figure 4B illustrates another possible configuration of battery cells in a battery module. In the arrangement of Figure 4B, a plurality of battery cells 36 are connected in a series connection of pairs of parallel cells (2p configuration). In this configuration, two adjacent battery cells are connected in parallel, and the pairs of parallel connected cells are connected in series. The voltage of each of the pairs of battery cells is monitored with a voltage sensor 40. The sensed voltage from each of the voltage sensors is provided to a battery management unit. The current into or out of the battery module is monitored by a current sensor 42 and provided to the battery management unit.

If desired, the battery cells could be connected in other configurations, such as a 3p configuration (three cells connected in parallel) or a 4p configuration (four cells connected in parallel) or any other appropriate configuration.

It will be appreciated that the battery pack and battery modules of Figures 2 to 4 are shown by way of example only, and other configurations are also possible. For example, the battery pack could comprise a plurality of battery cells connected in the appropriate series/parallel configuration without being grouped into battery modules. Furthermore, it would be possible to monitor the voltage and/or current of the battery module or the battery pack, or some other group of battery cells, rather than that of individual cells or groups of cells.

Battery packs for electric vehicle applications tend to degrade during use due to the arduous duty cycles that are encountered. When the battery packs no longer meet electric vehicle performance standards they may need to be replaced. It is therefore useful to have knowledge of the battery pack's state of health (SOH). Typically, SOH is a measurement of the remaining capacity of the battery as percentage of its original capacity. SOH represents the ability of the battery to store energy and deliver power relative to the beginning of life (BOL). Two existing definitions of SOH based on R (battery resistance) and Ah (battery capacity) are as follows:

$$SOH = 1 - \frac{R_t - R_{BOL}}{R_{BOL}} \times 100\%$$

$$SOH = 1 - \frac{Ah_t - Ah_{BOL}}{Ah_{BOL}} \times 100\%$$

However, any other appropriate definition of SOH could be used instead.

Knowledge of the battery's SOH is useful for an operator when organising maintenance and replacement schedules. Furthermore, if the SOH is monitored in real time, it can allow battery fault diagnosis which may help to prevent hazardous situations from arising. Real time SOH estimation can also provide knowledge about the battery performance that can help to manage the energy distribution. In addition, real time SOH estimation can help with accurate estimation of the battery state of charge (SOC). This may help to provide a reliable estimate of available range for the vehicle.

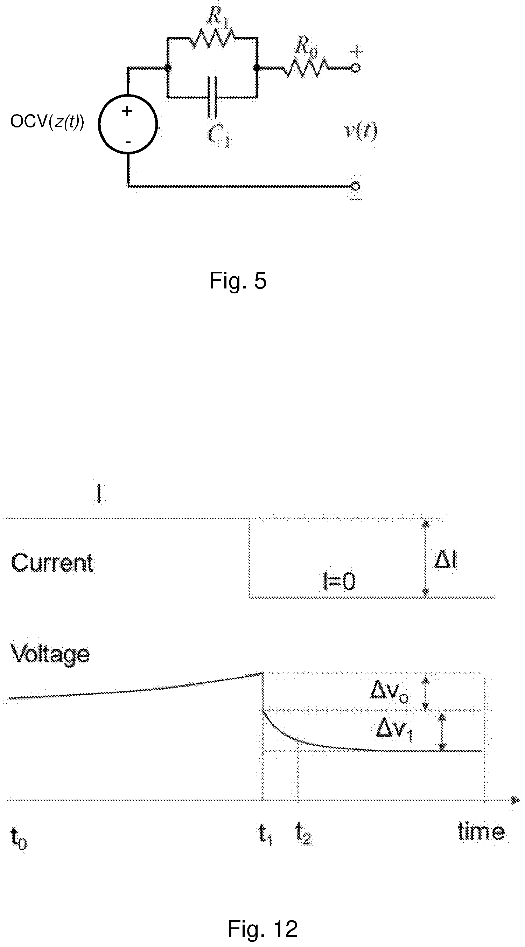

Figure 5 shows a first order equivalent circuit model for a typical battery. The battery may comprise any number of battery cells. In this model, the battery is considered to be a circuit consisting of a series connection of DC power supply, a parallel resistor/capacitor pair R1C1, and a resistor R0. The measured voltage v(t) is given by:

$$v(t) = OCV\big(z(t)\big) - R1\,i_{R1}(t) - R0\,i(t)$$

where OCV(z(t)) is the open circuit voltage, R0 is the ohmic resistance, R1 is the diffusion resistance, and i(t) is the current through the circuit.

An analysis of battery aging data has been carried out by the present applicant to identify parameters that can be used for estimating battery SOH. It has been found that there is a correlation between battery SOH and battery equivalent circuit model parameters.

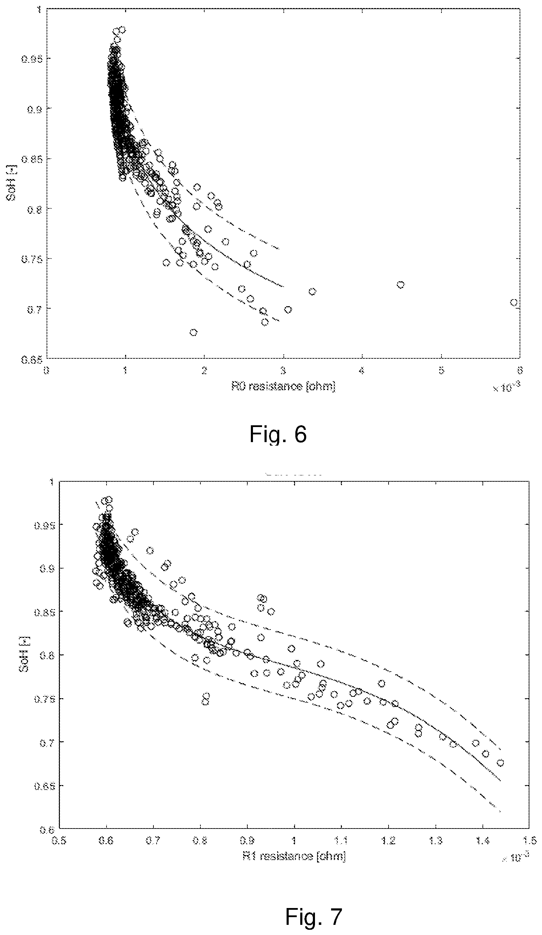

Figure 6 shows a plot of battery SOH against battery ohmic resistance R0. The plot of Figure 6 is taken from laboratory aging data obtained by analysing multiple battery packs. It can be seen that there is strong correlation between SOH and the value of R0. It can also be seen that the correlation is non-linear.

It has been found that the relationship between SOH and ohmic resistance R0 can be modelled as a function, such as an nth degree polynomial, or any other suitable type of function such as a spline, a Padé approximant, or a trigonometric polynomial using a Fourier series. Suitable techniques such as polynomial regression techniques can be used to fit a function to the data points, such techniques being known in the art. In the present case, it has been found that a seventh order polynomial (n=7) can provide a good fit, although other orders could be used instead. It can also be seen that most of the SOH is within defined error bounds (in this case, $\pm$ 2Ah). This can allow error bounds to be set.

Figure 7 shows a plot of battery SOH against diffusion resistance R1, also taken from laboratory aging data. It can be seen that there is strong non-linear correlation between SOH and the value of R1. The relationship between SOH and R1 can be modelled as a function such as an nth degree polynomial. Most of the SOH is within defined error bounds (in this case, $\pm$ 2Ah).

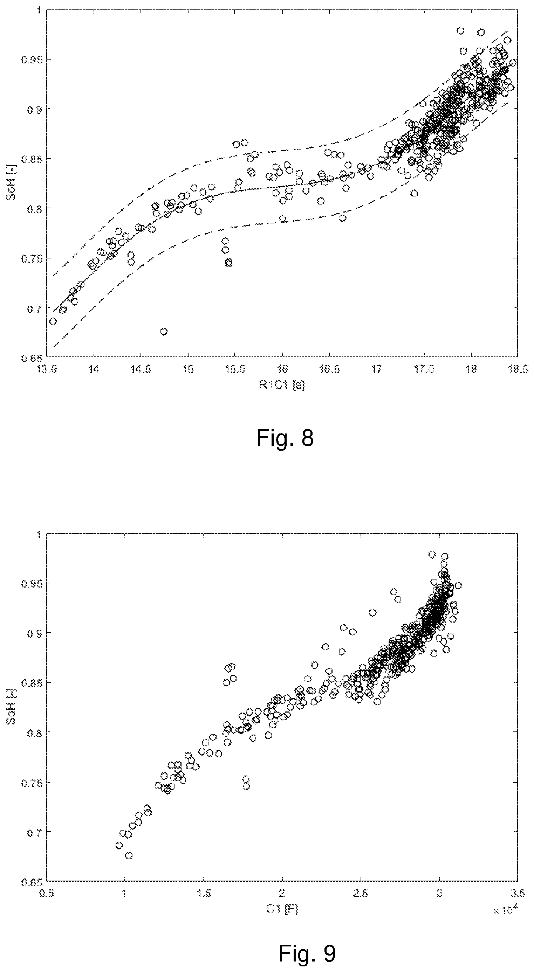

Figure 8 shows a plot of battery SOH against characterization time R1C1, again taken from laboratory aging data. It can be seen that there is strong non-linear correlation between SOH and the value of R1C1. The relationship between SOH and R1C1 can be modelled as a function such as an nth degree polynomial. Most of the capacity is within defined error bounds (in this case, $\pm$ 2Ah).

Figure 9 shows a plot of battery SOH against diffusion capacitance C1, again taken from laboratory aging data. It can be seen that there is strong non-linear correlation between SOH and the value of C1. The relationship between SOH and C1 can be modelled as a function such as an nth degree polynomial.

It has therefore been found that a correlation exists between battery SOH and each of battery ohmic resistance R0, diffusion resistance R1, characterization time R1C1 and diffusion capacitance C1. These correlations can be modelled as functions, such as polynomial functions. In preferred embodiments, some or all of these correlations are used to quickly and accurately estimate battery SOH on board the vehicle.

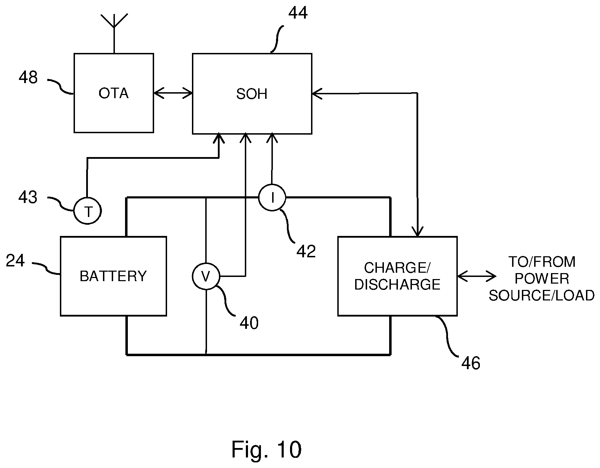

Figure 10 shows parts of a system for determining a state of health of a battery in an embodiment of the invention. Referring to Figure 10, the system comprises battery 24, state of health (SOH) estimation module 44, charge/discharge control module 46, voltage sensor 40, current sensor 42, temperature sensor 43 and over-the-air module 48. The system may be, for example, an onboard vehicular system for monitoring the SOH of a battery for an electric or hybrid electric vehicle. The battery 24 comprises a plurality of battery cells connected in the desired series and/or parallel configuration. For example, the battery may be a battery pack in any of the forms described above. The SOH estimation module 44 and charge/discharge control module 46 may be part of a battery management system as described above.

In operation, the charge/discharge control module 46 is used to control charging and discharging of the battery 24. The voltage sensor 40 is used to sense the voltage of the battery. The current sensor 42 is used to sense the current flowing into or out of the battery. The temperature sensor 43 is used to sensor the temperature of the battery. The sensed values of voltage, current and temperature are recorded over time. The sensed values of voltage, current and temperature are fed to the SOH estimation module 44. The SOH estimation module 44 calculates estimates of the state of health of the battery using the techniques discussed below.

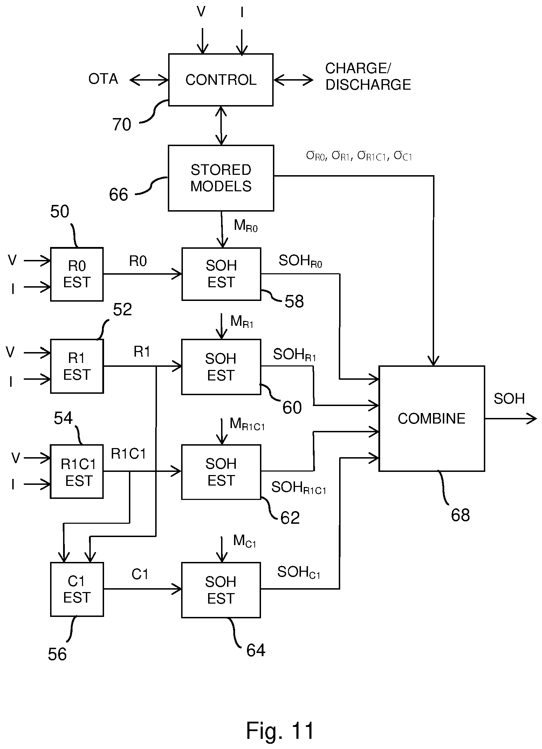

Figure 11 shows parts of the SOH estimation module in more detail. Referring to Figure 11, the module comprises R0 estimation unit 50, R1 estimation unit 52, R1C1 estimation unit 54, C1 estimation unit 56, R0 based SOH estimation unit 58, R1 based SOH estimation unit 60, R1C1 based SOH estimation unit 62, C1 based SOH estimation unit 64, storage unit 66, and combination unit 68. Overall operation of the SOH estimation module is managed by SOH control unit 70. For simplicity, connections between the SOH control unit 70 and other parts of the SOH estimation module are not shown. The SOH estimation module may be implemented, for example, as software routines executing on a processor with associated memory.

In operation, the R0 estimation unit 50 receives samples of voltage V and current I from the voltage and current sensors. The voltage and current values are used to calculate the current value of R0 in the equivalent circuit model, as will be explained below. The R1 estimation unit 52 receives the values of voltage V and current I and uses them to calculate the value of R1. The R1C1 estimation unit 54 receives the values of voltage V and current I and uses them to calculate the value of R1C1. The C1 estimation unit 56 receives the value of R1 from the R1 estimation unit 52 and the value of R1C1 from the R1C1 estimation unit 54 and uses them to calculate the value of C1.

In one embodiment, the values of R0, R1, R1C1 and C1 are estimated using a special charging protocol. This may be initiated by the control unit 70 when a new SOH value is required. This may be the case, for example, when a predetermined amount of time has elapsed or a predetermined amount of charging/discharging has occurred since the previous SOH estimate. In this embodiment, a step change in the charging current is applied during the charging process. For example, once the battery has reached a desired state of charge, the charging current is suddenly reduced to zero (or some other value less than the previous charging current). The voltage and current response to the change in charging current is then observed.

Figure 12 illustrates the values of the voltage V and the current I during initial charging and following the step change in current. Referring to Figure 12, charging is initiated at time $t_0$ under control of the charge/discharge control module. In this example, a substantially constant charging current is applied in order to charge the battery. As the battery is charged, its voltage V rises over time. The battery voltage is monitored by the SOH control unit 70. Once the battery voltage has reached a predetermined level (indicating a desired level of charge), the control unit 70 instructs the charge/discharge control module to reduce the charging current to zero (or some other value). At time $t_1$ the charge/discharge control module reduces the charging current to zero. In response to the drop in current, there is an immediate drop in voltage by a value $\Delta V_0$. This is followed by a gradual drop in voltage over time according to a relaxation curve given by the values of R1 and C1. During this time the voltage decays approximately exponentially and tends towards a total voltage drop of $\Delta V_1$. The values of voltage and current are monitored over time and used to estimate the values of R0, R1, R1C1 and C1.

The value of the ohmic resistance R0 in the equivalent circuit module can be calculated using the following equation.

$$R0 = \frac{\Delta v_0}{\Delta I}$$

The value of the diffusion resistance R1 in the equivalent circuit module can be calculated using the following equation.

$$R1 = \frac{\Delta v_1}{\Delta I}$$

Following the drop in current and the initial drop in voltage by the value $\Delta V_0$, the voltage will decay according to the following equation.

$$V(t) = \Delta V_1 e^{-\frac{t}{R1C1}}$$

Thus, the value of the characterization time (relaxation time) R1C1 can be estimated by determining the time taken for the voltage to decay to a predetermined level. For example, in one embodiment, the time $t_2$ at which the voltage has decayed to approximately 36.8% of its initial voltage (i.e., to approximately 36.8% of $\Delta V_1$) is determined. Since $e^{-1} \approx 0.368$, the value of R1C1 can then be calculated using the following equation.

$$R1C1 = t_1 - t_2$$

However, other predetermined voltage levels could be used instead. For example, the time taken for the voltage to decay to approximately 1.83% of its initial voltage at the start of the relaxation curve could be determined, in which case R1C1 would be approximately four times the time taken ($e^{-4} \approx 0.0183$).

The value of C1 can then be calculated from the values of R1 and R1C1 using the following equation.

$$C1 = \frac{R1C1}{R1}$$

Once the voltage has decayed to approximately its final value (sufficient to allow the values of R1 and R1C1 to be calculated), charging may be resumed. Depending on the battery and level of accuracy required, this may be after a time of approximately 3 to 5 minutes.

If desired, the temperature of the battery, as sensed by the temperature sensor 43, could be taken into account when estimating the values of R0, R1 and/or R1C1. For example, the value of each of these parameters could be corrected using a known relationship between the parameter and temperature. Alternatively, the estimates of the parameters could be used only when the temperature is within a predetermined range.

In an alternative embodiment, rather than using a special charging protocol, the vehicle's shut off response could be used instead. For example, when the vehicle is has been parked, the battery may experience a sudden drop in current. By monitoring the response to this drop in current, the values R0, R1, R1C1 and C1 may be calculated in a similar way to that described above.

If desired, the response to switching on the charging current, or any other event leading to a step change in current, could be monitored and used to estimate the values of R0, R1, R1C1 and C1 in a similar way. Alternatively, any other appropriate technique could be used as well or instead to estimate the values of the R0, R1, R1C1 and C1. For example, the values of one or more of R0, R1 and C1 could be estimated using Kalman filter estimation. If desired, a combination of different techniques could be used.

Referring back to Figure 11, the storage unit 66 stores models of the relationships between battery SOH and each of ohmic resistance R0, diffusion resistance R1, characterization time R1C1 and diffusion capacitance C1. These models $M_{R0}$, $M_{R1}$, $M_{R1C1}$ and $M_{C1}$ are in the form of polynomial functions derived from battery aging data in the manner described above.

The R0 based SOH estimation unit 58 receives the estimate value of R0 from the R0 estimation unit 50 and the model $M_{R0}$ of the relationship between SOH and the value of R0 from the storage unit 66. The R0 based SOH estimation unit 58 uses the model to estimate the SOH based on the value of R0. The estimated value $SOH_{R0}$ is output to the combination unit 68.

The R1 based SOH estimation unit 60 receives the estimated value of R1 from the R1 estimation unit 52 and the model $M_{R1}$ of the relationship between SOH and the value of R1 from the storage unit 66. The R1 based SOH estimation unit 60 uses the model to estimate the SOH based on the value of R1. The estimated value $SOH_{R1}$ is output to the combination unit 68.

The R1C1 based SOH estimation unit 62 receives the estimated value of R1C1 from the R1C1 estimation unit 54 and the model $M_{R1C1}$ of the relationship between SOH and the value of R1C1 from the storage unit 66. The R1C1 based SOH estimation unit 62 uses the model to estimate the SOH based on the value of R1C1. The estimated value $SOH_{R1C1}$ is output to the combination unit 68.

The C1 based SOH estimation unit 64 receives the estimated value of C1 from the C1 estimation unit 56 and the model $M_{C1}$ of the relationship between SOH and the value of C1 from the storage unit 66. The C1 based SOH estimation unit 64 uses the model to estimate the SOH based on the value of C1. The estimated value $SOH_{C1}$ is output to the SOH combination unit 68.

The SOH combination unit 68 receives the estimated values $SOH_{R0}$, $SOH_{R1}$, $SOH_{R1C1}$ and $SOH_{C1}$ and combines them to produce an overall estimate of the state of health SOH. The combination may be a weighted average of the individual SOH estimates. The weighting may be based on confidence levels of the various estimates.

For example, the estimates may be combined using the following equation.

$$SOH = \alpha_{R0} SOH_{R0} + \alpha_{R1} SOH_{R1} + \alpha_{R1C1} SOH_{R1C1} + \alpha_{C1} SOH_{C1}$$

The values of $\alpha_{R0}$, $\alpha_{R1}$, $\alpha_{R1C1}$ and $\alpha_{C1}$ may be calculated from the variances of the data sets from which the models of the relationships between battery SOH and the equivalent circuit model parameters are calculated. In one embodiment, the value of $\alpha_{R0}$ is calculated using the following equation.

$$\alpha_{R0} = \cfrac{\cfrac{1}{\sigma_{R0}^2}}{\cfrac{1}{\sigma_{R0}^2} + \cfrac{1}{\sigma_{R1}^2} + \cfrac{1}{\sigma_{R1C1}^2} + \cfrac{1}{\sigma_{C1}^2}}$$

Where $\sigma_{R0}$, $\sigma_{R1}$, $\sigma_{R1C1}$ and $\sigma_{C1}$ are the variances of $SOH_{R0}$, $SOH_{R1}$, $SOH_{R1C1}$ and $SOH_{C1}$, respectively. The values of $\alpha_{R1}$, $\alpha_{R1C1}$ and $\alpha_{C1}$ may be calculated in a similar way.

The values of $\sigma_{R0}$, $\sigma_{R1}$, $\sigma_{R1C1}$ and $\sigma_{C1}$ may be based on the sample variances of the data sets from which the models of the relationships between battery SOH and the equivalent circuit model parameters are calculated. The values of $\sigma_{R0}$, $\sigma_{R1}$, $\sigma_{R1C1}$ and $\sigma_{C1}$ may be calculated from the laboratory aging data used to form the models. The values of $\sigma_{R0}$, $\sigma_{R1}$, $\sigma_{R1C1}$ and $\sigma_{C1}$ are stored in the storage unit 66. The SOH combination unit 68 retrieves the variances from the storage unit and uses them to calculate the values of $\sigma_{R0}$, $\alpha_{R1}$, $\alpha_{R1C1}$ and $\alpha_{C1}$.

If desired, confidence levels in the estimated values of the equivalent circuit model parameters could be used when combining the state of health values as well or instead.

The final state of health value SOH is output to other parts of the battery management system for use in monitoring and managing battery performance. For example, the SOH may be used in organising maintenance and replacement schedules, battery fault diagnosis, managing the energy distribution, estimating battery SOC, and/or in any other way.

Although in the embodiment described above the battery ohmic resistance R0, the diffusion resistance R1, the diffusion capacitance C1 and the characterization time R1C1 are all used to estimate battery SOH, in practice it may be possible to use a subset of these parameters. For example, similar information is typically acquired from the diffusion capacitance C1 and the characterization time R1C1, and therefore in some embodiments only one of these parameters is used in the SOH estimation. Furthermore, if desired, one or both of ohmic resistance R0 and the diffusion resistance R1 could be omitted.

In the embodiment described above, polynomial functions are used to model the relationships between battery equivalent circuit model parameters. However, other types of function or look up tables could be used as well or instead. For example, in one alternative embodiment, look up tables are stored in the memory 66, and the estimation units 58, 60, 62, 64 use the values of the respective equivalent circuit parameters to look up the corresponding values of SOH in the memory. It will be appreciated that other techniques for modelling the relationship between capacity and the equivalent circuit model parameters could be used as well or instead.

Referring back to Figure 10, the onboard vehicular state of health system includes an over-the-air (OTA) module 48. The OTA module 48 allows the system to communicate with external systems, for example using radio frequency (RF) transmission. This can allow the system to communicate the SOH to an operator, for example, an operator of a fleet of vehicles. This may allow the operator to organise maintenance and replacement schedules based on the SOH. The OTA module 48 may also be used to receive new models of the relationships between SOH and the values of the equivalent circuit parameters R0, R1, R1C1 and C1 and their variances from a central store. The new models and variances may then replace those stored in the storage unit 66. This can allow the models which are used to calculate SOH to be updated, for example, as more laboratory aging data becomes available and better models are produced. The stored models and variances may also be updated using a wired connection for example during servicing.

In the arrangement described above the voltage and current of the whole battery are monitored and used to produce the SOH estimates. This can allow the SOH of the whole battery to be estimated. However, in practice, it may be desirable to monitor the SOH of individual battery cells or groups of battery cells. This may help with managing cell charge and discharge, and may provide an early indication of a potential fault in a cell or group of cells.

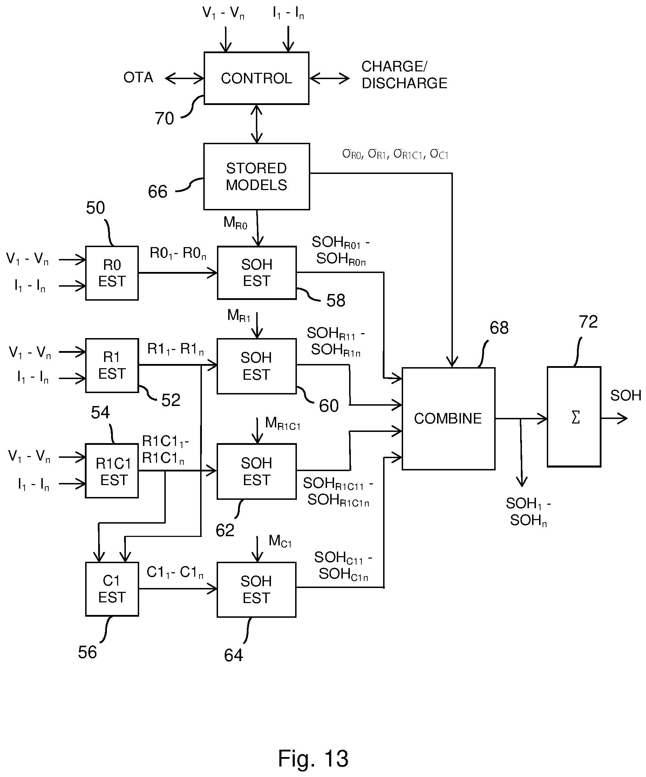

Figure 13 shows parts of an SOH estimation module in another embodiment. Referring to Figure 13, the module comprises R0 estimation unit 50, R1 estimation unit 52, R1C1 estimation unit 54, C1 estimation unit 56, R0 based SOH estimation unit 58, R1 based SOH estimation unit 60, R1C1 based SOH estimation unit 62, C1 based SOH estimation unit 64, storage unit 66, SOH combination unit 68 and SOH control unit 70, all of which may be the same as or similar to those described above. In this embodiment, each of the R0 estimation unit 50, the R1 estimation unit 52 and the R1C1 estimation unit 54 receives a plurality of sensed voltage values $V_1$ to $V_n$ as well as a sensed current I. The sensed voltage values $V_1$ - $V_n$ may be from the voltage sensors in a battery module of the type described above with reference to Figures 2 to 4. Thus, each voltage value $V_1$ to $V_n$ may be the voltage of an individual cell or group of cells in the battery module. The sensed current I may be the sensed current into or out of the battery module. However, other arrangements are also possible.

In operation, the R0 estimation unit 50 receives the values of voltage $V_1$ - $V_n$ and current I. The voltage and current values are used to calculate the value of R0 in the equivalent circuit model for each of cell or group of cells. The R0 estimation unit 50 then outputs the values $R0_1$ - $R0_n$ representing the calculated value of R0 for each cell or group of cells. Similarly, the R1 estimation unit 52 receives the values of voltage $V_1$ - $V_n$ and current I and uses them to calculate values of R1 for each cell or group of cells. The R1 estimation unit outputs the values $R1_1$ - $R1_n$ representing the calculated value of R1 for each cell or group of cells. The R1C1 estimation unit 54 receives the values of voltage $V_1$ - $V_n$ and current I and uses them to calculate values of R1C1 for each cell or group of cells. The R1C1 estimation unit outputs the values $R1C1_1$ - $R1C1_n$ representing the calculated value of R1C1 for each cell or group of cells. The C1 estimation unit 56 receives the values $R1_1$ - $R1_n$ from the R1 estimation unit 52 and the values of $R1C1_1$ - $R1C1_n$ from the R1C1 estimation unit 54 and uses them to calculate the values of C1 for each cell or group of cells. The C1 estimation unit 56 outputs the values $C1_1$ - $C1_n$ representing the calculated value of C1 for each cell or group of cells.

The R0 estimation unit 50, R1 estimation unit 52, R1C1 estimation unit 54 and C1 estimation unit 56 may use the same or similar techniques as those described above to calculate their respective values.

The values $R0_1$ - $R0_n$ are fed to the R0 based SOH estimation unit 58. The R0 based SOH estimation unit 58 also receives the stored model $M_{R0}$ of the relationship between SOH and the value of R0 from the storage unit 66. The R0 based SOH estimation unit 58 uses the model $M_{R0}$ and the values $R0_1$ - $R0_n$ to estimate the R0 based SOH for each cell or group of cells. The estimated R0 based SOH values $SOH_{R01}$ to $SOH_{R0n}$ are output to the SOH combination unit 68.

The values $R1_1$ - $R1_n$ are fed to the R1 based SOH estimation unit 60. The R1 based SOH estimation unit 60 also receives the stored model $M_{R1}$ of the relationship between SOH and the value of R1 from the storage unit 66. The R1 based SOH estimation unit 60 uses the model $M_{R1}$ and the values $R1_1$ - $R1_n$ to estimate the R1 based SOH for each cell or group of cells. The estimated R1 based SOH values $SOH_{R11}$ to $SOH_{R1n}$ are output to the SOH combination unit 68.

The values $R1C1_1$ - $R1C1_n$ are fed to the R1C1 based SOH estimation unit 62. The R1C1 based SOH estimation unit 62 also receives the stored model $M_{R1C1}$ of the relationship between SOH and the value of R1C1 from the storage unit 66. The R1C1 based SOH estimation unit 62 uses the model $M_{R1C1}$ and the values $R1C1_1$ - $R1C1_n$ to estimate the R1C1 based SOH for each cell or group of cells. The estimated R1C1 based SOH values $SOH_{R1C11}$ to $SOH_{R1C1n}$ are output to the SOH combination unit 68.

The values $C1_1$ - $C1_n$ are fed to the C1 based SOH estimation unit 64. The C1 based SOH estimation unit 64 also receives the stored model $M_{C1}$ of the relationship between SOH and the value of C1 from the storage unit 66. The C1 based SOH estimation unit 64 uses the model $M_{C1}$ and the values $C1_1$ - $C1_n$ to estimate the C1 based SOH for each cell or group of cells. The estimated C1 based SOH values $SOH_{C11}$ to $SOH_{C1n}$ are output to the SOH combination unit 68.

The SOH combination unit 68 receives the estimated SOH values for each cell or group of cells and combines them to produce an overall estimate of the state of health SOH for each cell or group of cells. The combination may be a weighted average of the individual SOH estimates. The weighting may be based on confidence levels of the various estimates, in the manner described above. The SOH combination unit 68 outputs the values $SOH_1$ - $SOH_n$ representing the estimated state of health for each cell or group of cells.

In this embodiment, the values $SOH_1$ - $SOH_n$ representing the estimated state of health for each cell or group of cells are received by an overall SOH calculating unit 72. The overall SOH calculating unit 72 averages the values $SOH_1$ - $SOH_n$ to produce an overall SOH value for the battery as a whole. The values $SOH_1$ - $SOH_n$ are also output individually. This may allow for example the detection of a faulty cell or group of cells.

In the arrangements described above, the SOH estimates are produced using estimates of the equivalent circuit model parameters R0, R1, R1C1 and C1. However, it would be possible for the SOH estimates to be produced using any subset of these parameters. For example, it would be possible to use only R1C1, or R1C1 and one or both of R0 and R1, or C1 either on its own or with one or both of R0 and R1, or any other appropriate combination.

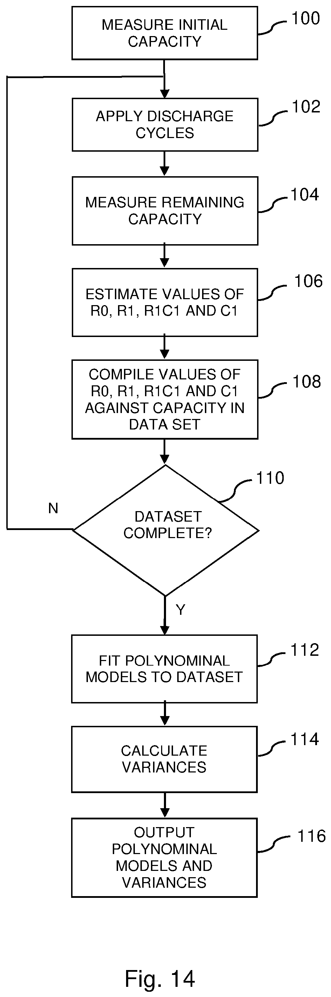

Figure 14 is a flowchart showing steps taken to obtain the models of the relationships between SOH and the equivalent circuit model parameters R0, R1, R1C1 and C1 in one embodiment. The steps of Figure 14 may be implemented, for example, as a software process executing on a processor with associated memory. Referring to Figure 14, in step 100 the initial capacity of a test battery at beginning of life is measured. In step 102 the test battery is degraded in controlled conditions by applying a plurality of discharge cycles. In step 104 the capacity of the degraded battery is measured. In step 106 the values of R0, R1, R1C1 and C1 at that capacity are estimated. In step 108 the values of R0, R1, R1C1 and C1 against capacity are compiled in a data set. In step 110 it is determined whether the data set is sufficiently complete to allow models to be produced. If the data set is not sufficiently complete, processing returns to step 102 and the battery aging process continues. If sufficient data are available, then in step 112 a polynomial model is fitted to the data points for each of the values R0, R1, R1C1 and C1 against capacity. This may be done using polynomial regression techniques such as are known in the art. In step 114 variances are calculated from the data sets, for example, based on the sample variances of the data points in the data sets. In step 116 the polynomial models and the variances are output for use in a SOH estimation system. For example, the polynomial models and the variances may be programmed into a new SOH estimation system or used to update an existing system during servicing or over the air. As an alternative, rather than fitting polynomial models to the data points, look up tables could be produced instead.

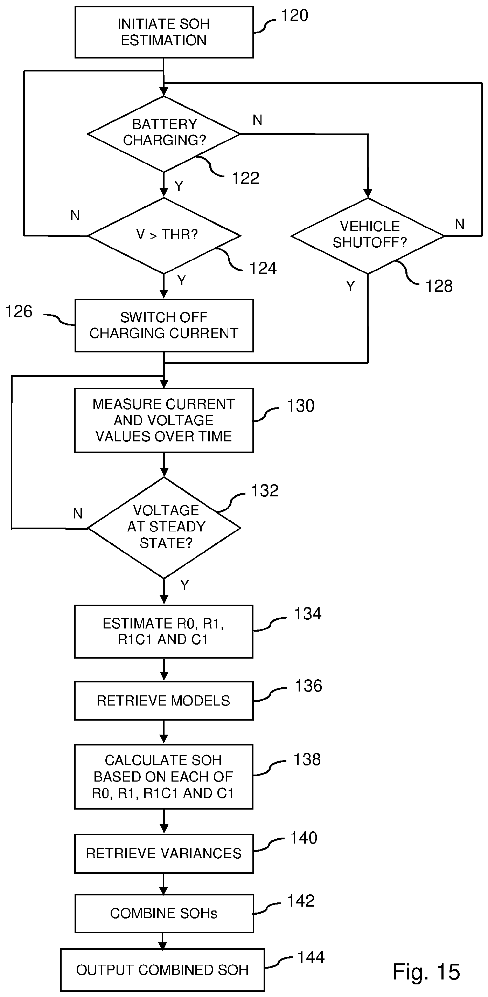

Figure 15 is a flowchart showing steps taken to calculate the SOH of a battery in one embodiment. The battery may comprise a plurality of cells connected in a series and/or parallel configuration in the manner described above. The steps of Figure 15 may be implemented, for example, as a software process executing on a processor with associated memory. For example, the steps of Figure 15 may be carried out by a system for determining the SOH of a battery as described above.

Referring to Figure 15, in step 120 the SOH estimation process is initiated when a new SOH value is required. This may be the case, for example, when a predetermined amount of time has elapsed or a predetermined amount of charging and/or discharging of the battery has occurred since the last SOH estimate. If desired, the temperature of the battery could be sensed, and the SOH estimation process initiated only if the temperature is within a predetermined temperature window. The temperature window may be defined by the laboratory test data on which the relationships between capacity and equivalent circuit model parameters are based. In step 122 it is determined whether the battery is being charged from an external power source. If the battery is being charged, then in step 124 it is determined whether the battery voltage is above a predetermined threshold. This step is taken in order to prioritize battery charging over SOH estimation for a battery with a low state of charge, but could be omitted. If the battery voltage is not above the threshold, then processing returns to step 122. On the other hand, if the voltage is above the threshold, then in step 126 the charging current is temporarily reduced to zero (or some other value). Processing then proceeds to step 130.

Returning to step 122, if it is determined that the battery is not being charged, then in step 128 it is determined whether a vehicle shut off has occurred. This may take place, for example, when the vehicle arrives at the garage. In such a situation the battery may experience a sudden drop in current. If it is determined that a vehicle shut off (or similar event) has occurred, then processing proceeds to step 130. On the other hand, if a vehicle shut off has not occurred, then processing returns to step 122.

In step 130 the battery current and voltage values over time in response to the drop in current are measured. This step may be performed for the battery as a whole and/or for individual cells or groups of cells. In step 132 it is determined whether the voltage has decayed to a substantially steady state. If the voltage has not decayed to a steady state, then processing returns to step 130. If the voltage has decayed to a steady state, then in step 134 the sampled values of voltage and current are used to calculate the values of R0, R1, R1C1 and C1 in the manner described above. At this point, if the charging current was switched off in step 126, then the charging current is switched back on and charging of the battery resumes.

In step 136 the polynomial models of R0, R1, R1C1 and C1 against capacity are retrieved from memory. In step 138 the polynomial models are used to estimate SOH based on the calculated values of R0, R1, R1C1 and C1. In step 140 the variances of the polynomial models are retrieved from memory. In step 142 the estimated values of SOH are combined using a weighted average based on the variances. In step 144 the combined SOH is output for further processing.

If desired the voltage and current response to switching on the charging current could be monitored and used to estimate SOH in a similar way.

Preferred features of the invention have been described above with reference to various embodiments. Where appropriate, features of one embodiment may be used with any other embodiment. Furthermore, it will be appreciated that the invention is not limited to these embodiments, and variations in detail may be made within the scope of the appended claims.

**Claims**

1.  Apparatus for determining a state of health, SOH, of a battery, the apparatus comprising:

    a voltage sensor (40) for sensing a voltage of the battery (24);
    a current sensor (42) for sensing a current through the battery;
    a parameter estimating unit (50, 52, 54, 56) arranged to estimate values of a plurality of equivalent circuit model parameters of the battery from the sensed voltage and current, wherein at least one of the equivalent circuit model parameters is based at least in part on an internal capacitance of the battery,
    **characterised by**:

    a storage unit (66) storing predetermined relationships between the equivalent circuit model parameters and the battery state of health; and
    a SOH calculation unit (58, 60, 62, 64) arranged to calculate a state of health of the battery based on the estimated values of the plurality of equivalent circuit model parameters using the predetermined relationships between the equivalent circuit model parameters and the battery state of health, wherein the SOH calculating unit (58, 60, 62, 64) is arranged to calculate a plurality of state of health values, each state of health value being calculated based on an estimated value of one of the equivalent circuit model parameters, and wherein the equivalent circuit model parameters are selected from: characterization time (R1C1), diffusion capacitance (C1), ohmic resistance (R0), and diffusion resistance (R1), wherein characterization time is the relaxation time of an RC circuit (R1C1).

2. Apparatus according to claim 1, wherein the values of the equivalent circuit model parameters are estimated from a response to a step change in current through the battery (24).

3. Apparatus according to claim 2, wherein the step change in current is a drop in charging current during charging of the battery, or a drop in current caused by vehicle shut off.

4. Apparatus according to any of the preceding claims, wherein the equivalent circuit model parameters comprise characterization time (R1C1) and the value of the characterization time is estimated from the time taken for the voltage to decay to a predetermined value following a step change in current.

5. Apparatus according to any of the preceding claims, wherein the equivalent circuit model parameters comprise ohmic resistance (R0) and the value of the ohmic resistance is estimated from an initial change in voltage following a step change in current.

6. Apparatus according to any of the preceding claims, wherein the equivalent circuit model parameters comprise diffusion resistance (R1) and the value of the diffusion resistance is estimated from a change in voltage over time according to a relaxation curve following a step change in current.

7. Apparatus according to any of the preceding claims, wherein the equivalent circuit model parameters comprise diffusion capacitance (C1) and the value of diffusion capacitance is estimated from values of diffusion resistance (R1) and characterization time (R1C1).

8. Apparatus according to any of the preceding claims, further comprising means (68) for combining the plurality of calculated state of health values to produce a combined state of health value.

9. Apparatus according to claim 8, wherein the combining means (68) is arranged to combine the state of health values based on variances of the relationships between the equivalent circuit model parameters and the battery state of health.

10. Apparatus according to any of the preceding claims, further comprising a temperature sensor (43) for sensing a temperature of the battery, wherein the value of at least one of the equivalent circuit model parameters is estimated based further on a sensed temperature.

11. Apparatus according to any of the preceding claims, wherein:

   the battery (24) comprises a plurality of battery cells (36);
   the apparatus comprises a plurality of voltage sensors (40), the plurality of voltage sensors arranged to sense a voltage of each of a plurality of cells or groups of cells;
   the parameter estimating unit (50, 52, 54, 56) is arranged to estimate a value of an equivalent circuit model parameter of each of the plurality of cells or groups of cells from the sensed voltage of that cell or group of cells and the sensed current; and
   the SOH calculating unit (58, 60, 62, 64) is arranged to calculate a state of health value of each of the plurality of cells or groups of cells based on the estimated value of the equivalent circuit model parameter of that cell or group of cells.

12. Apparatus according to claim 11, wherein:

   the parameter estimating unit (50, 52, 54, 56) is arranged to estimate values of a plurality of equivalent circuit model parameters of each of the plurality of cells or groups of cells from the sensed voltage of that cell or group of cells and the sensed current; and
   the SOH calculating unit (58, 60, 62, 64) is arranged to calculate a state of health of each of the plurality of cells or groups of cells based on the estimated values of the plurality of equivalent circuit model parameters of that cell or group of cells.

13. Apparatus according to claim 12, further comprising means (68) for combining the state of health value of each of the plurality of cells or groups of cells to produce a battery state of health value.

14. A battery comprising the apparatus for determining a state of health according to any of the preceding claims.

15. A method of determining a state of health of a battery, the method comprising:

sensing a voltage of the battery;
sensing a current through the battery;
estimating values of a plurality of equivalent circuit model parameters of the battery from the sensed voltage and current, wherein at least one of the equivalent circuit model parameters is based at least in part on an internal capacitance of the battery,
**characterised by**:

storing predetermined relationships between the equivalent circuit model parameters and the battery state of health; and
calculating a state of health of the battery based on the estimated values of the plurality of equivalent circuit model parameters using the predetermined relationships between the equivalent circuit model parameters and the battery state of health,
wherein a plurality of state of health values are calculated, each state of health value being calculated based on an estimated value of one of the equivalent circuit model parameters, and
wherein the equivalent circuit model parameters are selected from: characterization time (R1C1), diffusion capacitance (C1), ohmic resistance (R0), and diffusion resistance (R1), wherein characterization time is the relaxation time of an RC circuit (R1C1).

**Patentansprüche**

1. Einrichtung zur Bestimmung eines Gesundheitszustands (state of health, SOH) einer Batterie, wobei die Einrichtung umfasst:

einen Spannungssensor (40) zum Erfassen einer Spannung der Batterie (24);
einen Stromsensor (42) zum Erfassen eines Stromflusses durch die Batterie;
eine Parameterschätzeinheit (50, 52, 54, 56), die ausgelegt ist, um Werte einer Vielzahl von Ersatzschaltbildmodellparametern der Batterie aus der erfassten Spannung und dem Strom zu schätzen, wobei mindestens einer der Ersatzschaltbildmodellparameter mindestens teilweise auf einer internen Kapazität der Batterie basiert,
**gekennzeichnet durch**:

eine Speichereinheit (66), die vorbestimmte Beziehungen zwischen den Ersatzschaltbildmodellparametern und dem Batteriezustand speichert; und
eine SOH-Berechnungseinheit (58, 60, 62, 64), die ausgelegt ist, um einen Gesundheitszustand der Batterie auf der Grundlage der geschätzten Werte der Vielzahl von Ersatzschaltbildmodellparametern unter Verwendung der vorbestimmten Beziehungen zwischen den Ersatzschaltbildmodellparametern und dem Batteriezustand zu berechnen,

wobei die SOH-Berechnungseinheit (58, 60, 62, 64) ausgelegt ist, um eine Vielzahl von Gesundheitszustandswerten zu berechnen, wobei jeder Gesundheitszustandswert auf der Grundlage eines Schätzwertes eines der Ersatzschaltbildmodellparameter berechnet wird, und
wobei die Ersatzschaltbildmodellparameter aus den folgenden Größen ausgewählt werden: Charakterisierungszeit (R1C1), Diffusionskapazität (C1), ohmscher Widerstand (R0) und Diffusionswiderstand (R1), wobei die Charakterisierungszeit die Relaxationszeit eines RC-Schaltkreises (R1C1) ist.

2. Einrichtung nach Anspruch 1, wobei die Werte der Ersatzschaltbildmodellparameter aus einer Reaktion auf eine sprunghafte Änderung des Stroms durch die Batterie (24) geschätzt werden.

3. Einrichtung nach Anspruch 2, wobei die sprunghafte Änderung des Stroms ein Abfall des Ladestroms während des Ladevorgangs der Batterie oder ein durch das Abschalten des Fahrzeugs verursachter Stromabfall ist.

4. Einrichtung nach einem der vorstehenden Ansprüche, wobei die Ersatzschaltbildmodellparameter die Charakterisierungszeit (R1C1) umfassen und der Wert der Charakterisierungszeit aus der Zeit geschätzt wird, die die Spannung benötigt, um nach einer sprunghaften Änderung des Stroms auf einen vorbestimmten Wert abzufallen.

**5.** Einrichtung nach einem der vorstehenden Ansprüche, wobei die Ersatzschaltbildmodellparameter einen ohmschen Widerstand (R0) umfassen und der Wert des ohmschen Widerstands aus einer anfänglichen Spannungsänderung nach einer sprunghaften Änderung des Stroms abgeschätzt wird.

**6.** Einrichtung nach einem der vorstehenden Ansprüche, wobei die Ersatzschaltbildmodellparameter den Diffusionswiderstand (R1) umfassen und der Wert des Diffusionswiderstands aus einer Spannungsänderung über die Zeit gemäß einer Relaxationskurve nach einer sprunghaften Änderung des Stroms abgeschätzt wird.

**7.** Einrichtung nach einem der vorstehenden Ansprüche, wobei die Ersatzschaltbildmodellparameter die Diffusionskapazität (C1) umfassen und der Wert der Diffusionskapazität aus den Werten des Diffusionswiderstands (R1) und der Charakterisierungszeit (R1C1) abgeschätzt wird.

**8.** Einrichtung nach einem der vorstehenden Ansprüche, weiter umfassend Mittel (68) zum Kombinieren der Vielzahl berechneter Gesundheitszustandswerte zur Erzeugung eines kombinierten Gesundheitszustandswertes.

**9.** Einrichtung nach Anspruch 8, wobei das Kombinationsmittel (68) so ausgelegt ist, dass es die Werte für den Gesundheitszustand auf der Grundlage von Varianzen der Beziehungen zwischen den Ersatzschaltbildmodellparametern und dem Gesundheitszustand der Batterie kombiniert.

**10.** Einrichtung nach einem der vorstehenden Ansprüche, weiter umfassend einen Temperatursensor (43) zum Erfassen einer Temperatur der Batterie, wobei der Wert mindestens eines der Ersatzschaltbildmodellparameter auf der Grundlage einer erfassten Temperatur weiter geschätzt wird.

**11.** Einrichtung nach einem der vorstehenden Ansprüche, wobei:

die Batterie (24) eine Vielzahl von Batteriezellen (36) umfasst;
die Einrichtung eine Vielzahl von Spannungssensoren (40) umfasst, wobei die Spannungssensoren angeordnet sind, um eine Spannung jeder von einer Vielzahl von Zellen oder Zellgruppen zu erfassen;
die Parameterschätzeinheit (50, 52, 54, 56) so ausgelegt ist, um einen Wert eines Ersatzschaltbildmodellparameters jeder der Vielzahl von Zellen oder Zellgruppen aus der erfassten Spannung dieser Zelle oder Zellgruppe und dem erfassten Strom zu schätzen; und
die SOH-Berechnungseinheit (58, 60, 62, 64) ausgelegt ist, um für jede der Vielzahl von Zellen oder Zellgruppen einen Gesundheitszustandswert auf der Grundlage des geschätzten Wertes des Ersatzschaltbildmodellparameters dieser Zelle oder Zellgruppe zu berechnen.

**12.** Einrichtung nach Anspruch 11, wobei:

die Parameterschätzeinheit (50, 52, 54, 56) ausgelegt ist, um die Werte einer Vielzahl von Ersatzschaltbildmodellparametern jeder der Vielzahl von Zellen oder Zellgruppen aus der erfassten Spannung dieser Zelle oder Zellgruppe und dem erfassten Strom zu schätzen; und
die SOH-Berechnungseinheit (58, 60, 62, 64) ausgelegt ist, um einen Gesundheitszustand jeder der Vielzahl von Zellen oder Zellgruppen auf der Grundlage der geschätzten Werte der Vielzahl von den Ersatzschaltbildmodellparametern dieser Zelle oder Zellgruppe zu berechnen.

**13.** Einrichtung nach Anspruch 12, weiter umfassend Mittel (68) zum Kombinieren der Gesundheitszustandswerte jeder der Vielzahl von Zellen oder Zellgruppen zum Erzeugen eines Batterie-Gesundheitszustandswertes.

**14.** Batterie, umfassend die Einrichtung zur Bestimmung eines Gesundheitszustandes nach einem der vorstehenden Ansprüche.

**15.** Verfahren zur Bestimmung eines Gesundheitszustands einer Batterie, wobei das Verfahren umfasst:

Erfassen einer Batteriespannung;
Erfassen eines Stromflusses durch die Batterie;
Schätzen von Werten für eine Vielzahl von Ersatzschaltbildmodellparametern der Batterie aus der erfassten Spannung und dem Strom, wobei mindestens einer der Ersatzschaltbildmodellparameter mindestens teilweise auf einer internen Kapazität der Batterie basiert,
**gekennzeichnet durch**:

Speichern vorbestimmter Beziehungen zwischen den Ersatzschaltbildmodellparametern und dem Batteriezustand; und

Berechnen eines Gesundheitszustands der Batterie auf der Grundlage der geschätzten Werte der Vielzahl von Ersatzschaltbildmodellparametern unter Verwendung der vorbestimmten Beziehungen zwischen den Ersatzschaltbildmodellparametern und dem Batteriezustand,

wobei eine Vielzahl von Gesundheitszustandswerten berechnet wird, wobei jeder Gesundheitszustandswert auf der Grundlage eines Schätzwertes eines der Ersatzschaltbildmodellparameter berechnet wird, und

wobei die Ersatzschaltbildmodellparameter aus den folgenden Größen ausgewählt werden: Charakterisierungszeit (R1C1), Diffusionskapazität (C1), ohmscher Widerstand (R0) und Diffusionswiderstand (R1), wobei die Charakterisierungszeit die Relaxationszeit eines RC-Schaltkreises (R1C1) ist.

## Revendications

1. Appareil pour déterminer l'état de santé (SOH) d'une batterie, l'appareil comprenant :

   un capteur de tension (40) pour détecter une tension de la batterie (24) ;

   un capteur de courant (42) pour détecter un courant traversant la batterie ;

   une unité d'estimation de paramètres (50, 52, 54, 56) agencée pour estimer les valeurs d'une pluralité de paramètres de modèle de circuit équivalent de la batterie à partir de la tension et du courant détectés, dans lequel au moins un des paramètres de modèle de circuit équivalent est basé au moins en partie sur une capacité interne de la batterie,

   **caractérisé par** :

   une unité de stockage (66) stockant des relations prédéterminées entre les paramètres du modèle de circuit équivalent et l'état de santé de la batterie ; et

   une unité de calcul SOH (58, 60, 62, 64) agencée pour calculer l'état de santé de la batterie sur la base des valeurs estimées de la pluralité des paramètres du modèle de circuit équivalent en utilisant les relations prédéterminées entre les paramètres du modèle de circuit équivalent et l'état de santé de la batterie,

   dans lequel l'unité de calcul SOH (58, 60, 62, 64) est agencée pour calculer une pluralité de valeurs d'état de santé, chaque valeur d'état de santé étant calculée sur la base d'une valeur estimée de l'un des paramètres du modèle de circuit équivalent, et

   dans lequel les paramètres du modèle de circuit équivalent sont sélectionnés parmi : un temps de caractérisation (R1C1), une capacité de diffusion (C1), une résistance ohmique (R0) et une résistance de diffusion (R1), dans lequel le temps de caractérisation est le temps de relaxation d'un circuit RC (R1C1).

2. Appareil selon la revendication 1, dans lequel les valeurs des paramètres du modèle de circuit équivalent sont estimées à partir d'une réponse à un changement brusque du courant traversant la batterie (24).

3. Appareil selon la revendication 2, dans lequel le changement brusque de courant est une chute de courant de charge pendant la charge de la batterie, ou une chute de courant causée par l'arrêt du véhicule.

4. Appareil selon l'une quelconque des revendications précédentes, dans lequel les paramètres du modèle de circuit équivalent comprennent le temps de caractérisation (R1C1) et la valeur du temps de caractérisation est estimée à partir du temps nécessaire à la tension pour décroître jusqu'à une valeur prédéterminée après un changement brusque du courant.

5. Appareil selon l'une quelconque des revendications précédentes, dans lequel les paramètres du modèle de circuit équivalent comprennent une résistance ohmique (R0) et la valeur de la résistance ohmique est estimée à partir d'un changement initial de tension suite à un changement brusque de courant.

6. Appareil selon l'une quelconque des revendications précédentes, dans lequel les paramètres du modèle de circuit équivalent comprennent une résistance de diffusion (R1) et la valeur de la résistance de diffusion est estimée à partir d'une variation de tension au fil du temps selon une courbe de relaxation suivant un changement brusque de courant.

7. Appareil selon l'une quelconque des revendications précédentes, dans lequel les paramètres du modèle de circuit équivalent comprennent la capacité de diffusion (C1) et la valeur de la capacité de diffusion est estimée à partir des valeurs de la résistance de diffusion (R1) et du temps de caractérisation (R1C1).

8. Appareil selon l'une quelconque des revendications précédentes, comprenant en outre des moyens (68) pour combiner la pluralité de valeurs d'état de santé calculées afin de produire une valeur d'état de santé combinée.

9. Appareil selon la revendication 8, dans lequel les moyens de combinaison (68) sont agencés pour combiner les valeurs d'état de santé en fonction des variances des relations entre les paramètres du modèle de circuit équivalent et l'état de santé de la batterie.

10. Appareil selon l'une quelconque des revendications précédentes, comprenant en outre un capteur de température (43) pour détecter la température de la batterie, dans lequel la valeur d'au moins un des paramètres du modèle de circuit équivalent est estimée en outre sur la base d'une température détectée.

11. Appareil selon l'une quelconque des revendications précédentes, dans lequel :

la batterie (24) comprend une pluralité de cellules de batterie (36) ;
l'appareil comprend une pluralité de capteurs de tension (40), la pluralité de capteurs de tension étant agencés pour détecter la tension de chacune d'une pluralité de cellules ou de groupes de cellules ;
l'unité d'estimation des paramètres (50, 52, 54, 56) est agencée pour estimer la valeur d'un paramètre du modèle de circuit équivalent de chacune des cellules ou groupes de cellules à partir de la tension mesurée de cette cellule ou de ce groupe de cellules et du courant mesuré ; et
l'unité de calcul SOH (58, 60, 62, 64) est agencée pour calculer une valeur d'état de santé de chacune des pluralités de cellules ou de groupes de cellules sur la base de la valeur estimée du paramètre du modèle de circuit équivalent de cette cellule ou de ce groupe de cellules.

12. Appareil selon la revendication 11, dans lequel :

l'unité d'estimation des paramètres (50, 52, 54, 56) est agencée pour estimer les valeurs d'une pluralité de paramètres de modèle de circuit équivalent de chacune des pluralités de cellules ou de groupes de cellules à partir de la tension détectée de cette cellule ou de ce groupe de cellules et du courant détecté ; et
l'unité de calcul SOH (58, 60, 62, 64) est conçue pour calculer l'état de santé de chacune des cellules ou groupes de cellules en fonction des valeurs estimées des paramètres du modèle de circuit équivalent de cette cellule ou de ce groupe de cellules.

13. Appareil selon la revendication 12, comprenant en outre des moyens (68) pour combiner la valeur d'état de santé de chacune des pluralités de cellules ou de groupes de cellules afin de produire une valeur d'état de santé de la batterie.

14. Batterie comprenant l'appareil permettant de déterminer un état de santé selon l'une quelconque des revendications précédentes.

15. Procédé de détermination de l'état de santé d'une batterie, le procédé comprenant:

la détection de la tension de la batterie ;
la détection d'un courant traversant la batterie ;
estimation des valeurs de plusieurs paramètres du modèle de circuit équivalent de la batterie à partir de la tension et du courant mesurés, dans lequel au moins un des paramètres du modèle de circuit équivalent est basé au moins en partie sur une capacité interne de la batterie,
**caractérisé par** :

le stockage des relations prédéterminées entre les paramètres du modèle de circuit équivalent et l'état de santé de la batterie ; et
le calcul de l'état de santé de la batterie à partir des valeurs estimées de la pluralité des paramètres du modèle de circuit équivalent en utilisant les relations prédéterminées entre les paramètres du modèle de circuit équivalent et l'état de santé de la batterie,

dans lequel plusieurs valeurs d'état de santé sont calculées, chaque valeur d'état de santé étant calculée sur la base d'une valeur estimée de l'un des paramètres du modèle de circuit équivalent, et

dans lequel les paramètres du modèle de circuit équivalent sont sélectionnés parmi : le temps de caractérisation (R1C1), la capacité de diffusion (C1), la résistance ohmique (R0) et la résistance de diffusion (R1), dans lequel le temps de caractérisation est le temps de relaxation d'un circuit RC (R1C1).

Fig. 1

Fig. 2

Fig. 3

Fig. 4A

Fig. 4B

Fig. 5

Fig. 12

Fig. 6

Fig. 7

Fig. 8

Fig. 9

Fig. 10

Fig. 11

Fig. 13

```
┌─────────────────────┐
│  MEASURE INITIAL    │  ⟋─ 100
│     CAPACITY        │
└─────────────────────┘
           │
           ▼
┌─────────────────────┐
│  APPLY DISCHARGE    │  ⟋─ 102
│      CYCLES         │
└─────────────────────┘
           │
           ▼
┌─────────────────────┐
│  MEASURE REMAINING  │  ⟋─ 104
│     CAPACITY        │
└─────────────────────┘
           │
           ▼
┌─────────────────────┐
│  ESTIMATE VALUES OF │  ⟋─ 106
│  R0, R1, R1C1 AND C1│
└─────────────────────┘
           │
           ▼
┌─────────────────────┐
│  COMPILE VALUES OF  │
│  R0, R1, R1C1 AND C1│  ⟋─ 108
│ AGAINST CAPACITY IN │
│      DATA SET       │
└─────────────────────┘
           │
           ▼
         ⟋ 110
        ◇◇◇◇◇◇
   N  ◇         ◇
◀─────◇ DATASET  ◇
      ◇ COMPLETE?◇
        ◇◇◇◇◇◇
           │ Y
           ▼
┌─────────────────────┐
│  FIT POLYNOMINAL    │  ⟋─ 112
│  MODELS TO DATASET  │
└─────────────────────┘
           │
           ▼
┌─────────────────────┐
│    CALCULATE        │  ⟋─ 114
│    VARIANCES        │
└─────────────────────┘
           │
           ▼
┌─────────────────────┐
│     OUTPUT          │
│   POLYNOMINAL       │  ⟋─ 116
│  MODELS AND         │
│   VARIANCES         │
└─────────────────────┘
```

Fig. 14

INITIATE SOH ESTIMATION — 120

BATTERY CHARGING? — 122

N

Y

V > THR? — 124

N

Y

SWITCH OFF CHARGING CURRENT — 126

VEHICLE SHUTOFF? — 128

N

Y

MEASURE CURRENT AND VOLTAGE VALUES OVER TIME — 130

VOLTAGE AT STEADY STATE? — 132

N

Y

ESTIMATE R0, R1, R1C1 AND C1 — 134

RETRIEVE MODELS — 136

CALCULATE SOH BASED ON EACH OF R0, R1, R1C1 AND C1 — 138

RETRIEVE VARIANCES — 140

COMBINE SOHs — 142

OUTPUT COMBINED SOH — 144

Fig. 15

**EP 4 409 308 B1**

## REFERENCES CITED IN THE DESCRIPTION

### Patent documents cited in the description

- WO 2020246558 A
- GB 2593187 A
- GB 2598534 A
- GB 2594916 A